# FASCICULE DE BREVET EUROPEEN

(11) **EP 2 873 153 B1**
(45) Date de publication et mention de la délivrance du brevet: **13.02.2019**
(21) Numéro de dépôt: 13744735.5
(22) Date de dépôt: 11.07.2013
(51) Int. Cl.: H03K 17/082, H03K 17/16

(54) **DISPOSITIF DE COMMANDE D'AU MOINS UN TRANSISTOR**
VORRICHTUNG ZUR STEUERUNG VON MINDESTENS EINEM TRANSISTOR
DEVICE FOR CONTROLLING AT LEAST ONE TRANSISTOR

(30) Priorité: 13.07.2012 FR 1256834
(43) Date de publication de la demande: 20.05.2015
(73) Titulaire: Valeo Systèmes De Contrôle Moteur, 95800 Cergy Saint Christophe (FR)
(72) Inventeur: BOUCHEZ, Boris, F-95800 Cergy (FR); GRENIER, Mathieu, F-Houilles 78800 (FR)
(74) Mandataire: Argyma
(86) Numéro de dépôt international: PCT/FR2013/051664
(87) Numéro de publication internationale: WO 2014/009668

(56) Documents cités:
- EP-A1- 2 418 776
- FR-A1- 2 671 241
- US-A- 5 926 012
- US-B1- 6 459 324
- TAKIZAWA S ET AL: "A new di/dt control gate drive circuit for IGBTs to reduce EMI noise and switching losses", POWER ELECTRONICS SPECIALISTS CONFERENCE, 1998. PESC 98 RECORD. 29TH A NNUAL IEEE FUKUOKA, JAPAN 17-22 MAY 1998, NEW YORK, NY, USA,IEEE, US, vol. 2, 17 mai 1998 (1998-05-17), pages 1443-1449, XP010294730, DOI: 10.1109/PESC.1998.703241 ISBN: 978-0-7803-4489-1

## Description

La présente invention concerne un dispositif de commande d'au moins un transistor. Les transistors sont couramment utilisés pour réaliser des bras de convertisseur statique. Ces transistors sont habituellement commandés par un circuit de commande, encore appelé « driver », configuré pour injecter un courant dans l'électrode de commande du transistor pour le rendre passant et pour recevoir du courant depuis cette même électrode de commande lorsque le transistor se bloque.

Lors du blocage du transistor, une surtension peut apparaître à ses bornes, la tension aux bornes du transistor étant au sens de la présente demande la tension entre les électrodes du transistor autres que l'électrode de commande du transistor. On va donner ci-après un exemple d'apparition d'une surtension aux bornes du transistor lors d'un blocage de ce dernier.

Lorsque le transistor appartient à un bras formant un court-circuit, le courant circulant dans ce bras augmente de façon importante. Un blocage du transistor pour éviter un échauffement trop important de ce dernier du fait de la valeur élevée du courant parcourant le bras est souhaitable. Néanmoins, lors d'un tel blocage du transistor, une surtension importante peut apparaître à ses bornes, puisque la tension aux bornes du transistor peut devenir égale à la somme de la tension du bras et de la tension aux bornes d'inductances parasites dans le transistor. Cette surtension peut dégrader, voire détruire, le transistor.

Il existe donc un besoin pour réduire la surtension apparaissant dans le transistor lorsque ce transistor se bloque, notamment dans le cas où le transistor appartient à un bras d'un convertisseur statique et que le transistor se bloque alors que ledit bras forme un court-circuit.

Des solutions connues pour réduire cette surtension consistent à :
- limiter la tension entre les électrodes autres que celles de commande du transistor à l'aide d'une diode haute tension et, le cas échéant, d'une diode Zener et d'une résistance en série,
- utiliser un circuit de commande du transistor imposant deux valeurs différentes de potentiel électrique pour l'électrode de commande du transistor: une première valeur correspondant à la commande à l'état passant du transistor et une deuxième valeur, inférieure à la première valeur, correspondant au blocage du transistor. Du fait que le potentiel électrique de l'électrode de commande est plus faible lors du blocage, la surtension est réduite,
- prévoir deux résistances de grille distinctes entre l'électrode de commande et le circuit de commande, l'une dédiée au blocage du transistor lorsque le bras auquel il appartient forme un court-circuit et l'autre dédiée aux autres cas de blocage, la résistance de grille dédiée au blocage en cas de court-circuit ayant une valeur supérieure à celle de l'autre résistance de grille afin de limiter les surtensions.

Aucune de ces solutions ne réalise un compromis satisfaisant entre les facteurs suivants : coût de la solution, rapidité de réaction, encombrement lié à l'implémentation de la solution et pertes électriques induites lorsque la solution est implémentée.

Un exemple de dispositif de commande est divulgué dans EP 2 418 776.

Il existe un besoin pour remédier aux inconvénients des solutions précédentes.

L'invention vise à répondre à ce besoin et elle y parvient, selon l'un de ses aspects, à l'aide d'un dispositif de commande selon la revendication indépendante 1.

L'invention utilise notamment le fait que, lorsque le transistor se bloque, il se comporte comme un condensateur entre l'électrode de commande et une des autres électrodes du transistor. La réduction de la valeur du courant circulant de l'électrode de commande vers le circuit de commande principal grâce à l'injection du courant auxiliaire permet de réduire la variation temporelle du courant circulant entre les autres électrodes du transistor et donc la surtension dans le transistor, en partie liée aux inductances parasites.

L'injection de courant auxiliaire permet donc de ralentir, au sens temporel, la variation du courant circulant entre les électrodes du transistor autres que son électrode de commande.

Le circuit de commande auxiliaire selon l'invention peut permettre une réaction rapide lorsque l'on détecte l'apparition de valeurs de tension importantes aux bornes d'inductance(s) parasite(s) du transistor, sans générer un encombrement important dans le dispositif, sans être onéreux et sans occasionner de pertes importantes.

En outre, le circuit de commande auxiliaire peut être compatible avec les drivers traditionnels et il peut être utilisé en complément de ces derniers.

Au sens de la présente invention, « relié » sans précision additionnelle peut signifier « directement relié », c'est-à-dire sans composant intermédiaire, ou « indirectement relié », c'est-à-dire via un ou plusieurs composants intermédiaires.

Selon le mode de fonctionnement principal, seul le circuit de commande principal peut interagir avec le transistor, tandis que selon le mode de fonctionnement auxiliaire, le circuit de commande auxiliaire interagit également avec le transistor.

Le mode auxiliaire peut n'être appliqué que lorsqu'une condition prédéfinie est vérifiée.

La condition prédéfinie peut se rapporter à la valeur de la dérivée temporelle du courant circulant entre les électrodes du transistor autres que l'électrode de commande, plus précisément au résultat de la comparaison de cette valeur à une valeur seuil.

Le circuit de commande auxiliaire peut être configuré pour injecter le courant auxiliaire lorsque du courant circule de l'électrode de commande du transistor vers le circuit de commande principal. Ce cas correspond au blocage du transistor. Ce blocage peut être commandé.

Lorsque cette valeur de dérivée temporelle du courant circulant entre les électrodes du transistor autres que l'électrode de commande est supérieure à la valeur seuil, on peut appliquer le mode auxiliaire de fonctionnement en injectant le courant auxiliaire. Lorsque le transistor fait partie d'un bras d'un convertisseur statique, la valeur seuil peut être choisie de manière à être dépassée lorsque le transistor se bloque après qu'un court-circuit est formé dans ledit bras. Du fait de ce dépassement de la valeur seuil, des surtensions de valeur nuisible peuvent apparaître aux bornes du transistor lorsque celui-ci se bloque.

En variante, la valeur seuil peut être choisie pour être dépassée lorsque le transistor se bloque sans qu'un court-circuit ait préalablement été formé dans le bras auquel il appartient.

Le dispositif peut comporter un organe de détection de la vérification de la condition prédéfinie. Cet organe est par exemple un organe de mesure de la tension aux bornes de l'inductance parasite d'une autre électrode du transistor. La mesure de cette tension, image linéaire de la dérivée temporelle du courant circulant dans cette électrode, peut permettre la comparaison mentionnée ci-dessus. L'inductance parasite en question a par exemple une valeur de l'ordre de quelques nH.

Le dispositif peut comprendre une résistance de commande (similaire à la résistance de grille mentionnée ci-dessus) interposée entre l'électrode de commande et le circuit de commande principal. Le circuit de commande auxiliaire peut être disposé de manière à injecter le courant auxiliaire dans un noeud interposé entre la résistance de commande et l'électrode de commande. Contrairement aux solutions connues, aucune autre résistance de commande dédiée à des cas spécifiques de blocage du transistor n'est par exemple prévue.

Le dispositif comprend un montage amplificateur de puissance, notamment de type « push-pull », disposé entre le circuit de commande principal et l'électrode de commande du transistor, le circuit de commande auxiliaire étant disposé de manière à ce que le montage amplificateur de puissance soit traversé par le courant auxiliaire injecté lorsque le mode de fonctionnement auxiliaire est appliqué. Du fait de la position du circuit de commande auxiliaire en amont du montage amplificateur de puissance, les composants de ce circuit de commande auxiliaire peuvent être dimensionnés pour une puissance moindre et être moins coûteux.

Le circuit de commande auxiliaire peut être configuré pour asservir la valeur de la dérivée temporelle du courant circulant entre les électrodes du transistor autres que l'électrode de commande autour d'une valeur de consigne. Cette valeur de consigne peut être choisie pour éviter de dégrader le transistor. La valeur de consigne peut être inférieure ou égale à la valeur seuil, cette dernière étant ou non choisie pour être dépassée lorsque le transistor se bloque après que le bras forme un court-circuit ou lorsque le transistor se bloque et indépendamment de la formation de ce court-circuit.

Le circuit de commande auxiliaire comprend par exemple :
- une première résistance en série entre une des autres électrodes du transistor et un transistor faisant partie de l'organe de détection de la vérification de la condition prédéfinie, et
- une deuxième résistance en série entre ledit transistor faisant partie de l'organe de détection de la vérification de la condition prédéfinie et une source de tension, la borne de cette deuxième résistance reliée au transistor de l'organe de détection de la vérification de la condition prédéfinie étant en outre reliée à l'électrode de commande d'un transistor parcouru par le courant auxiliaire lorsque ce dernier est injecté.

L'asservissement peut être obtenu grâce au choix de la valeur du rapport entre la première et la deuxième résistance. Ce rapport est par exemple compris entre un et dix, étant par exemple égal à cinq.

Le transistor peut être un transistor de type IGBT, l'électrode de commande étant la grille. Dans ce cas, lors du blocage du transistor, on peut considérer qu'un condensateur existe entre la grille et l'émetteur du transistor. Pour décider si la condition prédéfinie est satisfaite, on peut surveiller l'évolution temporelle du courant dans l'inductance parasite de l'émetteur.

Dans ce cas et lorsque le transistor fait partie d'un bras comprenant deux transistors en série, l'inductance parasite de l'émetteur est :
- pour un transistor en bas du bras, l'inductance parasite entre la masse de commande du transistor (encore appelée « émetteur de commande du transistor ») et la masse puissance,
- pour un transistor en haut du bras, l'inductance parasite entre la masse de commande du transistor et le collecteur de l'autre transistor.

En variante, le transistor peut être un transistor à effet de champ, l'électrode de commande étant la grille. Dans ce cas, lors du blocage du transistor, on peut considérer qu'un condensateur existe entre la grille et la source du transistor. Pour décider si la condition prédéfinie est satisfaite, on peut surveiller l'évolution temporelle du courant dans l'inductance parasite de la source.

Dans ce cas et lorsque le transistor fait partie d'un bras comprenant deux transistors en série, l'inductance parasite de la source est :
- pour un transistor en bas du bras, l'inductance parasite entre la masse de commande du transistor (encore appelée « source de commande du transistor ») et la masse puissance,
- pour un transistor en haut du bras, l'inductance parasite entre la masse de commande du transistor et le drain de l'autre transistor.

En variante, le transistor peut être un transistor bipolaire, l'électrode de commande étant la base. Dans ce cas, lors du blocage du transistor, on peut considérer qu'un condensateur existe entre la base et l'émetteur du transistor. Pour décider si la condition prédéfinie est satisfaite, on peut surveiller l'évolution temporelle du courant dans l'inductance parasite de l'émetteur.

Dans ce cas et lorsque le transistor fait partie d'un bras comprenant deux transistors en série, l'inductance parasite de l'émetteur est :
- pour un transistor en bas du bras, l'inductance parasite entre la masse de commande du transistor (encore appelée « émetteur de commande du transistor ») et la masse puissance,
- pour un transistor en haut du bras, l'inductance parasite entre la masse de commande du transistor et le collecteur de l'autre transistor.

Le circuit de commande auxiliaire peut comprendre une source d'énergie électrique permettant de générer le courant auxiliaire. Cette source d'énergie électrique peut être propre ou non au circuit de commande auxiliaire, étant par exemple partagée avec le circuit de commande principal.

Le dispositif peut permettre de commander plusieurs transistors, par exemple plusieurs transistors appartenant au même bras ou plusieurs transistors en parallèles dans un même bras ou plusieurs transistors appartenant à des bras différents.

Le convertisseur statique auquel appartient le bras peut faire partie d'un circuit embarqué sur un véhicule, par exemple un véhicule hybride ou électrique. Ce convertisseur statique peut faire partie d'un circuit de charge d'une batterie haute tension du véhicule. En variante, il peut faire partie d'un circuit d'alimentation du stator ou du rotor du moteur électrique du véhicule. En variante encore, il peut faire partie d'un circuit assurant à la fois la charge de la batterie haute tension et l'alimentation du stator du moteur électrique, un tel circuit étant par exemple divulgué dans la demande WO 2010/057893.

Le convertisseur statique peut être un convertisseur de tension continu/continu ou un convertisseur de tension continu/alternatif, encore appelé redresseur ou onduleur selon son utilisation.

L'invention a encore pour objet, selon un autre de ses aspects, un procédé de commande d'un transistor selon la revendication indépendante 8.

La condition prédéfinie peut se rapporter à la valeur de la dérivée temporelle du courant circulant entre les électrodes du transistor autres que l'électrode de commande, plus précisément au résultat de la comparaison de cette valeur avec une valeur seuil.

La valeur seuil peut être choisie de manière à être dépassée par la valeur prise par la dérivée temporelle du courant circulant entre les électrodes du transistor autres que l'électrode de commande lors du blocage du transistor après qu'un court-circuit est formé dans le bras d'un convertisseur statique auquel le transistor appartient. Ce bras peut comprendre en série avec le transistor au moins une cellule de commutation. Le circuit auxiliaire est dans ce cas dédié au blocage du transistor après court-circuit dans le bras.

En variante, la valeur seuil peut être choisie de manière à être dépassée par la valeur prise par la dérivée temporelle du courant circulant entre les électrodes du transistor autres que l'électrode de commande lors du blocage du transistor sans qu'un court-circuit ne soit nécessairement formé dans ledit bras. Le circuit auxiliaire peut dans ce cas appliquer le mode auxiliaire pour chaque blocage du transistor, dès lors que celui-ci risque d'être dégradé.

On peut par exemple pour détecter la condition prédéfinie mesurer la tension aux bornes de l'inductance parasite d'une des électrodes du transistor autres que l'électrode de commande, par exemple l'émetteur lorsqu'il s'agit d'un transistor bipolaire ou de type IGBT et la source lorsqu'il s'agit d'un transistor à effet de champ.

Tout ou partie des caractéristiques mentionnées en rapport avec le dispositif ci-dessus s'appliquent au procédé de commande. Plus particulièrement, le convertisseur statique peut être un convertisseur de tension continu/continu ou d'un convertisseur de tension continu/alternatif.

L'invention pourra être mieux comprise à la lecture de la description qui va suivre d'exemples de mise en oeuvre de celle-ci et à l'examen du dessin annexé sur lequel :
- la figure 1 représente de façon schématique un dispositif de commande d'un transistor selon l'art antérieur,
- la figure 2 représente de façon schématique un modèle équivalent du transistor du dispositif de la figure 1 lorsque le transistor se bloque,
- la figure 3 représente de façon schématique un exemple de dispositif de commande,
- la figure 4 représente un exemple de mise en oeuvre du dispositif selon la figure 3,
- les figures 5 représentent différentes grandeurs électriques associées au transistor du dispositif selon la figure 1 et du dispositif selon la figure 4, et
- la figure 6 représente un dispositif selon l'invention.

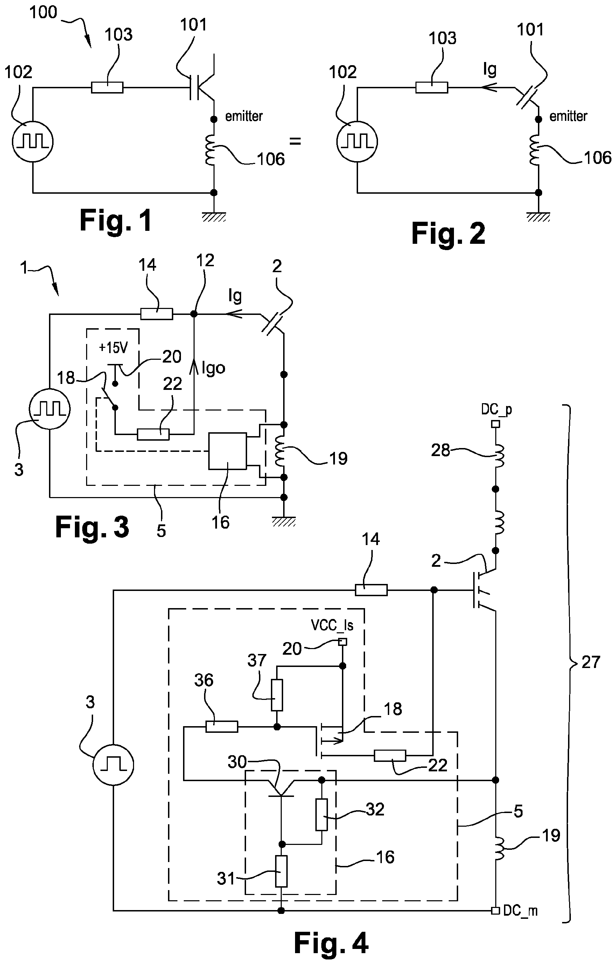

On a représenté à la figure 1 un exemple de dispositif 100 de commande d'au moins un transistor 101 selon l'art antérieur. Outre le transistor 101 qui est ici un transistor de type IGBT, le dispositif 100 comprend un circuit de commande principal 102, parfois désigné sous la terminologie anglaise « driver », configuré pour commander l'état du transistor 101. Une résistance de grille 103 est interposée entre le circuit de commande principal 102 et la grille du transistor 101, cette résistance de grille 103 étant parcourue par le courant circulant entre la grille et le circuit de commande principal 102.

On a également représenté sur la figure 1 l'inductance parasite 106 de l'émetteur du transistor 101.

La figure 2 représente le modèle équivalent que l'on peut utiliser entre l'émetteur et la grille du transistor 101 lorsque le transistor 101 se bloque. Un courant i_{g} circule alors de la grille du transistor 101 vers le circuit de commande principal 102, ce qui correspond à une décharge du condensateur selon le modèle de la figure 2.

On va maintenant décrire en référence à la figure 3 de façon schématique la solution proposée par l'invention pour répondre aux inconvénients des solutions selon l'art antérieur.

La figure 3 représente un dispositif de commande 1 d'au moins un transistor 2. Ce transistor fait dans l'exemple décrit partie d'un bras d'un convertisseur statique, par exemple un convertisseur de tension continu/continu ou un convertisseur de tension continu/aternatif plus couramment connu sous le nom d'onduleur ou de redresseur. Une diode de roue libre non représentée peut être montée en anti-parallèle du transistor 2 pour former une cellule de commutation du bras.

Le transistor 2 est dans l'exemple décrit de type IGBT et il comprend une électrode de commande étant la grille et deux autres électrodes étant l'émetteur et le collecteur.

Dans l'exemple considéré, tous les transistors du bras peuvent simultanément se retrouver à l'état passant, de sorte que le bras peut former un court-circuit. Le courant circulant entre les électrodes du transistor 2 autres que l'électrode de commande peut alors fortement augmenter.

Le dispositif 1 comprend en outre :
- un circuit de commande principal 3 relié à la grille du transistor 2 et configuré pour, selon un mode de fonctionnement principal, commander l'état du transistor, et
- un circuit de commande auxiliaire 5 représenté de façon très schématique sur la figure 3.

Le circuit 5 est configuré pour appliquer un mode de fonctionnement auxiliaire en injectant un courant auxiliaire i_{g0} dans la grille du transistor 2, comme cela sera décrit ultérieurement, en un noeud 12 disposé dans l'exemple de la figure 3 entre la grille du transistor 2 et une résistance de commande 14 montée en série avec le circuit de commande principal 3.

Comme représenté sur la figure 3, le circuit de commande auxiliaire 5 peut comprendre un organe 16 configuré pour détecter la vérification d'une condition prédéfinie avant d'appliquer le mode de fonctionnement auxiliaire. Cette condition prédéfinie se rapporte dans l'exemple décrit au résultat de la comparaison entre la valeur de la dérivée temporelle du courant dans l'émetteur du transistor et une valeur seuil. Cette condition prédéfinie permet notamment de déterminer si le blocage du transistor 2 intervient alors qu'un court-circuit est formé dans le bras dont fait partie ce transistor 2, l'apparition d'un tel court-circuit se traduisant par une variation brutale de la dérivée temporelle du courant circulant entre l'émetteur et le collecteur du transistor 2 lorsque le transistor 2 se bloque. On peut ainsi choisir la valeur seuil de manière à détecter ce blocage du transistor alors qu'un court-circuit était formé.

Dans le cas présent, l'organe de détection 16 mesure la tension aux bornes de l'inductance parasite 19 du transistor 2. Cette tension apparaît, dans le cas où le transistor 2 est situé en bas du bras du convertisseur, entre la masse de commande du transistor 2 et la masse de puissance du transistor 2, ces deux masses étant accessibles sur le module de transistor utilisé.

Selon la comparaison effectuée par l'organe 16 entre la valeur mesurée et une valeur seuil de tension, une commande est appliquée sur un interrupteur 18 lors du blocage du transistor 2 pour permettre ou non l'injection du courant auxiliaire i_{g0}. Cet interrupteur 18 est par exemple monté en série entre une source d'énergie électrique 20 et le noeud 12. La source d'énergie électrique 20 délivre par exemple une tension de 15 V et elle fait dans l'exemple décrit partie du circuit de commande principal 3.

Le cas échéant, une résistance 22 peut également être intégrée au circuit de commande auxiliaire 5.

Le courant i_{g0} injecté dans le noeud 12 est choisi pour s'opposer au courant i_{g} circulant dans la grille du transistor 2. Ainsi, le courant circulant dans la grille du transistor n'est plus égal à i_{g} mais à i_{g} - i_{g0}. Le courant i_{g0} peut avoir une amplitude comprise entre 1 A et 10 A.

Lors du blocage du transistor 2, c'est-à-dire lorsque le condensateur selon le modèle de la figure 2 ou 3 se décharge, le courant circulant dans la grille du transistor 2 est réduit, ce qui réduit également la variation temporelle du courant circulant entre l'émetteur et le collecteur du transistor 2. Or, comme déjà mentionné, cette variation temporelle est à l'origine de surtensions pouvant dégrader le transistor 2. On réduit ainsi les surtensions apparaissant aux bornes du transistor lors du blocage de ce dernier.

La figure 4 représente la structure d'un exemple de dispositif 1. Le transistor 2 appartient à un bras 27 dont l'autre transistor 28 est représenté sous la forme d'une inductance, pour que l'établissement du court-circuit dans le bras 27 ne dépende que de l'état du transistor 2.

Comme représenté, l'organe 16 comprend un transistor bipolaire 30, et deux résistances 31 et 32. Dans cet exemple, le transistor 30 est de type NPN. Son émetteur est directement relié à l'émetteur du transistor 2 tandis que sa base est directement reliée à une première extrémité de la résistance 31 dont la deuxième extrémité est reliée à une borne de sortie du transistor 2, cette dernière borne de sortie pouvant être reliée à la masse ou non selon la position du transistor 2 dans le bras du convertisseur statique. La résistance 32 est montée entre la base du transistor 30 et son émetteur.

L'organe 16 permet ainsi de mesurer la valeur de la tension aux bornes de l'inductance parasite 19 présente entre l'émetteur du transistor 2 et sa borne de sortie. Lorsque la valeur de tension aux bornes de l'inductance 19 devient supérieure à la valeur seuil, le transistor 30 change d'état et devient passant, et ce changement d'état est perçu par l'interrupteur 18 et provoque sa fermeture, de manière à permettre l'injection du courant i_{g0} depuis la source d'énergie électrique 20 dans le noeud 12.

Dans l'exemple de la figure 4, l'interrupteur 18 est un transistor à effet de champ de type MOSFET et il est associé à deux résistances 36 et 37. La résistance 36 est interposée entre la grille du transistor 18 et le collecteur du transistor bipolaire 30 tandis que la résistance 37 est interposée entre la grille et la source du transistor 18. La source d'énergie électrique 20 est reliée à la source du transistor 18. Le drain du transistor 18 est par ailleurs relié à la résistance 22.

On choisit par exemple les valeurs numériques suivantes pour les éléments du dispositif de commande 1 de la figure 4. Les résistances 14, 22, 31, 32, 36 et 37 ont respectivement pour valeur d'impédance 4,7 Ω, 1 Ω, 100 Ω, 1 kΩ, 4,7 Ω et 1 kΩ. La source d'énergie électrique 20 fournit une tension d'environ 15 V. L'inductance parasite 19 a par exemple une valeur de 2,7 nH.

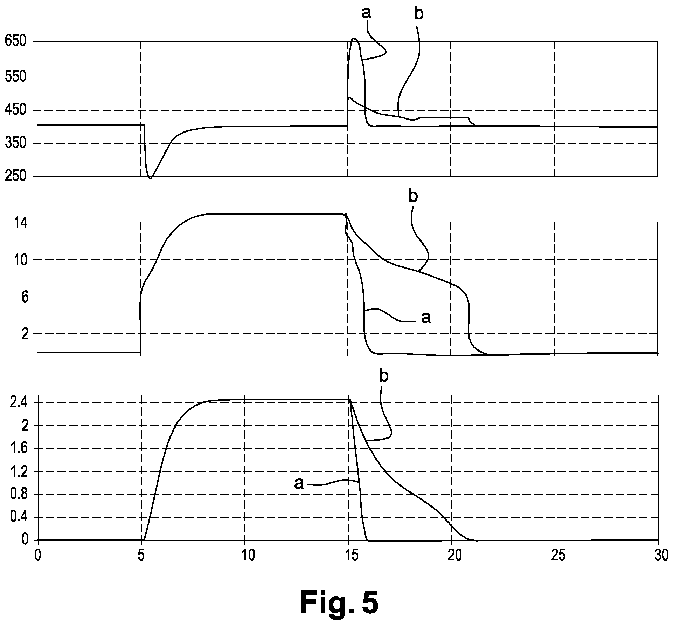

La figure 5 représente :
- sur sa partie supérieure l'évolution de la tension en V entre le collecteur et l'émetteur du transistor 2,
- sur sa partie médiane l'évolution de la tension en V entre la grille et l'émetteur du transistor 2, et
- sur sa partie inférieure l'évolution du courant en kA circulant du collecteur vers l'émetteur du transistor 2.

Dans l'exemple représenté, le transistor 2 est passant entre les instants 5 µs et 15 µs et il est commandé pour se bloquer à 15 µs Du fait du modèle choisi pour l'autre transistor 28, un court-circuit est établi dans le bras 27 entre les instants 5 µs et 15 µs.

Sur chaque partie de la figure 5, la courbe a) correspond au dispositif 100 selon la figure 1 tandis que la courbe b) correspond au dispositif 1 selon la figure 4. Comme on peut le voir sur la partie inférieure de la figure 5, la diminution du courant circulant entre l'émetteur et le collecteur du transistor 2 du fait du passage à l'état bloqué de ce dernier est beaucoup plus lente lorsque le circuit de commande auxiliaire 5 selon l'invention injecte le courant auxiliaire i_{g0} dans l'électrode de commande du transistor 2. Ainsi, comme représenté sur la partie supérieure de la figure 5, la surtension apparaissant à l'instant 15 µs entre le collecteur et l'émetteur du transistor 2 est significativement réduite.

Par exemple, on constate sur la partie supérieure de cette figure 5 que la surtension selon la courbe a) est de l'ordre de plus de 250 V tandis qu'elle n'est que de l'ordre d'environ 80 V selon la courbe b). On réduit ainsi de façon importante cette surtension et les conséquences négatives y étant associées.

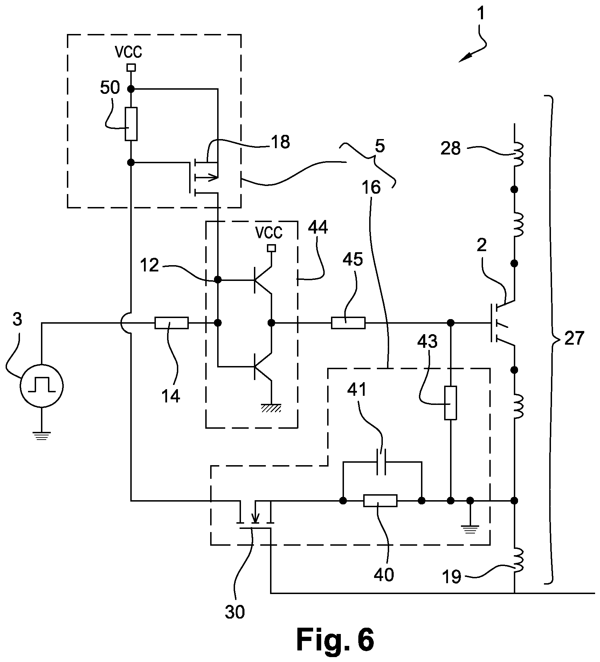

On va maintenant décrire en référence à la figure 6 un dispositif de commande selon l'invention. Dans ce cas, l'organe de détection 16 comprend un transistor à effet de champ 30 de type MOSFET dont la grille est reliée à la borne de sortie du transistor 2, dont la source est reliée l'émetteur du transistor 2 par l'intermédiaire d'un filtre formé par un montage en parallèle d'une première résistance 40 et d'un condensateur 41.

En outre, une résistance 43 est reliée entre la grille du transistor 2 et son émetteur.

Dans cet exemple, le dispositif 1 comprend un montage amplificateur de type push-pull 44. Le montage 44 est formé de façon connue à l'aide d'un transistor PNP et d'un transistor NPN de même gain et en montage collecteur commun. Les bases de ces transistors sont également directement reliées. Dans cet exemple, la résistance 14 est interposée entre le circuit de commande principal 3 et les bases des transistors du montage 44 tandis qu'une autre résistance 45 est interposée entre le montage push-pull 44 et le transistor 2.

L'interrupteur 18 du circuit de commande auxiliaire 5 est dans cet exemple un transistor MOSFET dont la grille est reliée au drain du transistor 30 de l'organe de détection 6, dont la source est reliée à la source d'énergie électrique 20 et dont le drain est relié aux bases des transistors du montage 44.

Une deuxième résistance 50 est associée au transistor MOSFET 18, cette dernière reliant la grille de ce transistor 18 à sa source.

Dans cet exemple, la valeur seuil n'est pas choisie de manière à être dépassée lorsque le transistor 2 se bloque après un court-circuit dans le bras 27. Elle peut être dépassée alors que le transistor 2 se bloque sans qu'un court-circuit ne soit préalablement formé dans le bras 27.

On choisit par exemple les valeurs numériques suivantes pour les éléments du dispositif de commande 1 de la figure 6. Les résistances 14, 40, 43, 45 et 50 ont respectivement pour valeur d'impédance 100 Ω, 200 Ω, 47 kΩ, 3 Ω et 1 kΩ. La source d'énergie électrique fournit une tension d'environ 15 V. L'inductance parasite 19 a par exemple une valeur de 2 nH. Le condensateur 41 a par exemple une capacité de 220 pF. Le rapport entre la première résistance 40 et la deuxième résistance 50 est dans cet exemple de cinq, et cette valeur de rapport permet d'asservir la valeur de tension aux bornes de l'inductance parasite 19 à une valeur pour laquelle le transistor 2 n'est pas dégradé.

Lorsque la tension aux bornes de l'inductance parasite 19 est supérieure à la valeur seuil, le transistor 30 devient passant, ce qui rend également le passant le transistor 18. Le courant i_{g0} peut alors circuler depuis la source 20 à travers le transistor 18, le montage 44 et jusqu'à la grille du transistor 2.

L'invention n'est pas limitée aux exemples qui viennent d'être décrits.

En particulier, bien que le transistor 2 ait été décrit comme un transistor de type IGBT, il peut s'agir d'un transistor à effet de champ ou d'un transistor bipolaire.

Bien que dans l'exemple décrit, un seul transistor soit commandé par le dispositif de commande 1, plusieurs transistors d'un même bras de convertisseur statique pourraient être commandés par le dispositif 1 afin de freiner leur blocage.

L'expression « comprenant un » doit être comprise comme étant synonyme de l'expression « comprenant au moins un », sauf lorsque le contraire est spécifié.

## Revendications

1. Dispositif de commande (1) d'au moins un transistor (2), comprenant :
- ledit transistor (2), ce dernier comprenant une électrode de commande et deux autres électrodes,
- un circuit de commande principal (3) configuré pour, selon un mode de fonctionnement principal, commander l'état du transistor (2),
- un montage amplificateur de puissance (44), notamment de type « push-pull », disposé entre le circuit de commande principal (3) et l'électrode de commande du transistor,
- un circuit de commande auxiliaire (5) configuré pour, selon un mode de fonctionnement auxiliaire, injecter un courant auxiliaire (i_{g0}) s'opposant au courant (i_{g}) circulant entre le circuit de commande principal (3) et l'électrode de commande du transistor (2), le circuit de commande auxiliaire (5) étant disposé de manière à ce que ce montage amplificateur de puissance (44) soit traversé par le courant injecté (i_{g0}) lorsque le mode de fonctionnement auxiliaire est appliqué.

2. Dispositif selon la revendication 1, le mode de fonctionnement auxiliaire étant appliqué lorsqu'une condition prédéfinie est vérifiée.

3. Dispositif selon la revendication 2, la condition prédéfinie se rapportant à la valeur de la dérivée temporelle du courant circulant entre les électrodes du transistor (2) autres que l'électrode de commande.

4. Dispositif selon la revendication 3, comportant un organe de détection de la vérification de la condition prédéfinie (16), configuré pour mesurer la tension aux bornes de l'inductance parasite (19) d'une des électrodes du transistor (2) autres que l'électrode de commande du transistor (2).

5. Dispositif selon l'une quelconque des revendications précédentes, comprenant une résistance de commande (14) interposée entre l'électrode de commande du transistor (2) et le circuit de commande principal (3), le circuit de commande auxiliaire (5) étant disposé de manière à injecter le courant auxiliaire (i_{g0}) dans un noeud (12) interposé entre la résistance de commande (14) et l'électrode de commande du transistor (2).

6. Dispositif selon l'une quelconque des revendications 1 à 5, le circuit de commande auxiliaire (5) étant configuré pour asservir la valeur de la dérivée temporelle du courant circulant entre les électrodes du transistor (2) autres que l'électrode de commande autour d'une valeur de consigne.

7. Dispositif selon les revendications 4 et 6, le circuit de commande auxiliaire (5) comprenant :
- une première résistance (40) en série entre une des autres électrodes du transistor (2) et un transistor (30) faisant partie de l'organe de détection de la vérification de la condition prédéfinie (16), et
- une deuxième résistance (50) en série entre ledit transistor (30) faisant partie de l'organe de détection de la vérification de la condition prédéfinie (16) et une source de tension (20), la borne de cette deuxième résistance (50) reliée au transistor (30) de l'organe de détection de la vérification de la condition prédéfinie (16) étant en outre reliée à l'électrode de commande d'un transistor (18) parcouru par le courant auxiliaire (i_{g0}) lorsque ce dernier est injecté, l'asservissement étant obtenu grâce au choix de la valeur du rapport entre la première (40) et la deuxième (50) résistance.

8. Procédé de commande d'un transistor (2) comprenant une électrode de commande et deux autres électrodes à l'aide d'un dispositif (1) selon l'une des revendications précédentes, le mode de fonctionnement auxiliaire étant appliqué lorsqu'une condition prédéfinie est détectée.

9. Procédé selon la revendication 8, la condition prédéfinie se rapportant à la valeur de la dérivée temporelle du courant circulant entre les électrodes du transistor (2) autres que l'électrode de commande.

10. Procédé selon la revendication 9, le transistor (2) appartenant à un bras (27) d'un convertisseur statique, ledit bras comprenant au moins en outre une cellule de commutation en série avec le transistor (2), procédé dans lequel la condition prédéfinie permet de déterminer si le transistor (2) se bloque alors qu'un court-circuit était préalablement formé dans le bras (27).

11. Procédé selon la revendication 9 ou 10, dans lequel on détecte si la condition prédéfinie est vérifiée en mesurant la tension aux bornes de l'inductance parasite d'une des électrodes du transistor (2) autres que l'électrode de commande.

## Patentansprüche

1. Vorrichtung zur Steuerung (1) von mindestens einem Transistor (2), umfassend:
- den Transistor (2), wobei dieser eine Steuerelektrode und zwei andere Elektroden umfasst,
- einen Haupt-Steuerkreis (3), der konfiguriert ist, um gemäß einem Haupt-Betriebsmodus den Zustand des Transistors (2) zu steuern,
- eine Leistungsverstärkeranordnung (44) insbesondere vom Typ "push-pull", die zwischen dem Haupt-Steuerkreis (3) und der Steuerelektrode des Transistors angeordnet ist,
- einen Hilfs-Steuerkreis (5), der konfiguriert ist, um gemäß einem Hilfs-Betriebsmodus einen Hilfsstrom (i_{g0}) einzuspeisen, der dem Strom (i_{g}) entgegenwirkt, der zwischen dem Haupt-Steuerkreis (3) und der Steuerelektrode des Transistors (2) fließt, wobei der Hilfs-Steuerkreis (5) derart angeordnet ist, dass diese Leistungsverstärkeranordnung (44) von dem eingespeisten Strom (i_{g0}) durchflossen wird, wenn der Hilfs-Betriebsmodus angewendet wird.

2. Vorrichtung nach Anspruch 1, wobei der Hilfs-Betriebsmodus angewendet wird, wenn eine vorher bestimmte Bedingung überprüft ist.

3. Vorrichtung nach Anspruch 2, wobei sich die vorher bestimmte Bedingung auf den Wert der Zeitableitung des Stroms bezieht, der zwischen den Elektroden des Transistors (2) fließt, die keine Steuerelektrode sind.

4. Vorrichtung nach Anspruch 3, aufweisend ein Detektionsorgan der Überprüfung der vorher festgelegten Bedingung (16), das konfiguriert ist, um die Spannung an den Klemmen der parasitären Induktanz (19) einer der Elektroden des Transistors (2) zu messen, die keine Steuerelektrode des Transistors (2) sind.

5. Vorrichtung nach einem der vorangehenden Ansprüche, umfassend einen Steuerwiderstand (14) zwischen der Steuerelektrode des Transistors (2) und dem Haupt-Steuerkreis (3), wobei der Hilfs-Steuerkreis (5) derart angeordnet ist, dass der Hilfsstrom (i_{g0}) in einen Knoten (12) zwischen dem Steuerwiderstand (14) und der Steuerelektrode des Transistors (2) eingespeist wird.

6. Vorrichtung nach einem der Ansprüche 1 bis 5, wobei der Hilfs-Steuerkreis (5) konfiguriert ist, um den Wert der Zeitableitung des Stroms, der zwischen den Elektroden des Transistors (2) fließt, die keine Steuerelektrode sind, um einen Sollwert zu steuern.

7. Vorrichtung nach den Ansprüchen 4 und 6, wobei der Hilfs-Steuerkreis (5) umfasst:
- einen ersten Widerstand (40) in Reihe zwischen einer der anderen Elektroden des Transistors (2) und einem Transistor (30), der Teil des Detektionsorgans der Überprüfung der vorher festgelegten Bedingung (16) ist, und
- einen zweiten Widerstand (50) in Reihe zwischen dem Transistor (30), der Teil des Detektionsorgans der Überprüfung der vorher festgelegten Bedingung (16) ist, und einer Spannungsquelle (20), wobei die Klemme dieses zweiten Widerstands (50), die mit dem Transistor (30) des Detektionsorgans der Überprüfung der vorher festgelegten Bedingung (16) verbunden ist, ferner mit der Steuerelektrode eines Transistors (18) verbunden ist, der von dem Hilfsstrom (i_{g0}) durchflossen wird, wenn dieser eingespeist wird.

8. Verfahren zur Steuerung eines Transistors (2), umfassend eine Steuerelektrode und zwei andere Elektroden mit Hilfe einer Vorrichtung (1) nach einem der vorangehenden Ansprüche, wobei der Hilfs-Betriebsmodus angewendet wird, wenn eine vorher festgelegte Bedingung ermittelt ist.

9. Verfahren nach Anspruch 8, wobei sich die vorher festgelegte Bedingung auf den Wert der Zeitableitung des Stroms bezieht, der zwischen den Elektroden des Transistors (2) fließt, die keine Steuerelektrode sind.

10. Verfahren nach Anspruch 9, wobei der Transistor (2) zu einem Arm (27) eines statischen Konverters gehört, wobei der Arm ferner mindestens eine Umschaltzelle in Reihe mit dem Transistor (2) umfasst, wobei bei dem Verfahren die vorher festgelegte Bedingung erlaubt zu bestimmen, ob der Transistor (2) blockiert, obwohl zuvor ein Kurzschluss in dem Arm (27) stattgefunden hatte.

11. Verfahren nach Anspruch 9 oder 10, wobei durch Messen der Spannung an den Klemmen der parasitären Induktanz einer der Elektroden des Transistors (2), die keine Steuerelektrode sind, ermittelt wird, ob die vorher festgelegte Bedingung überprüft ist.

## Claims

1. Device (1) for controlling at least one transistor (2), comprising:
- said transistor (2), the latter comprising a control electrode and two other electrodes,
- a main control circuit (3) configured so as to control the state of the transistor (2) in a main operating mode,
- a power amplifier circuit (44), notably of the "push-pull" type, positioned between the main control circuit (3) and the control electrode of the transistor,
- an auxiliary control circuit (5) configured to inject, in an auxiliary operating mode, an auxiliary current (i_{g0}) opposed to the current (i_{g}) flowing between the main control circuit (3) and the control electrode of the transistor (2), the auxiliary control circuit (5) being arranged in such a way that the injected current (i_{g0}) flows through the power amplifier circuit (44) when the auxiliary operating mode is used.

2. Device according to claim 1, the auxiliary operating mode being used when a predetermined condition is verified.

3. Device according to claim 2, the predetermined condition relating to the value of the time derivative of the current flowing between the electrodes of the transistor (2) other than the control electrode.

4. Device according to claim 3, comprising an element for detecting the presence of the predetermined condition (16), the element being configured to measure the voltage at the terminals of the parasitic inductance (19) of one of the electrodes of the transistor (2) other than the control electrode of the transistor (2).

5. Device according to any of the preceding claims, comprising a control resistance (14) interposed between the control electrode of the transistor (2) and the main control circuit (3), the auxiliary control circuit (5) being arranged so as to inject the auxiliary current (i_{g0}) into a node (12) interposed between the control resistance (14) and the control electrode of the transistor (2).

6. Device according to any of claims 1 to 5, the auxiliary control circuit (5) being configured to lock the value of the time derivative of the current flowing between the electrodes of the transistor (2) other than the control electrode around a set-point value.

7. Device according to claims 4 and 6, the auxiliary control circuit (5) comprising:
- a first resistance (40) in series between one of the other electrodes of the transistor (2) and a transistor (30) forming part of the element for detecting the presence of the predetermined condition (16), and
- a second resistance (50) in series between said transistor (30) forming part of the element for detecting the presence of the predetermined condition (16) and a voltage source (20), the terminal of said second resistance (50) connected to the transistor (30) of the element for detecting the presence of the predetermined condition (16) being additionally connected to the control electrode of a transistor (18) through which the auxiliary current (i_{g0}) flows when the latter is injected, the locking being achieved by the choice of the value of the ratio between the first (40) and the second (50) resistance.

8. Method for controlling a transistor (2) comprising a control electrode and two other electrodes, by means of a device (1) according to any of the preceding claims, the auxiliary operating mode being used when a predetermined condition is detected.

9. Method according to claim 8, the predetermined condition relating to the value of the time derivative of the current flowing between the electrodes of the transistor (2) other than the control electrode.

10. Method according to claim 9, the transistor (2) belonging to a branch (27) of a static converter, said arm additionally comprising at least a switching cell in series with the transistor (2), in which method the predetermined condition makes it possible to determine whether the transistor (2) is cut off when a short circuit has previously developed in the branch (27).

11. Method according to claim 9 or 10, wherein the presence of the predetermined condition is detected by measuring the voltage at the terminals of the parasitic inductance of one of the electrodes of the transistor (2) other than the control electrode.
